# DEMANDE DE BREVET EUROPEEN

(11) **EP 4 770 287 A1**
(43) Date de publication de la demande: **01.07.2026**
(21) Numéro de dépôt: 25226402.3
(22) Date de dépôt: 22.12.2025
(51) Int. Cl.: H05K 3/28, H05K 3/00, H05K 1/14, H10W 74/01, H10W 74/10, H05K 1/02, H10W 40/25, H10W 70/40, H10W 72/60, H10W 90/00

(54) **MODULE DE PUISSANCE ET SON PROCÉDÉ DE FABRICATION**

(30) Priorité: 29.12.2024 FR 2415358
(71) Demandeur: Valeo eAutomotive Germany GmbH, 91056 Erlangen (DE)
(72) Inventeur: VERCAMBRE, Virginie, 94000 CRETEIL (FR); MASSOL, Laurent, 94460 VALENTON (FR); AYTOUS, Hicham, 72300 Sable Sur Sarthe (FR); PIERRE, Thomas, 94460 VALENTON (FR); KOPP, Gabriel, 94460 VALENTON (FR)
(74) Mandataire: Valeo Powertrain Systems

(57) **Abrégé**

L'invention concerne un module de puissance (1) destiné à être connecté à une grille de connexion, comprenant :
- Une carte de puissance (101) comprenant un substrat (1011), deux portions de puissance (1012) disposées sur le substrat,
- Une carte de signal (11) montée sur la carte de puissance,
- Des plots de connexion (12, 22) électriquement conducteurs, chaque plot de connexion comprenant une première face (121, 221) et une deuxième face (122, 222), la première face étant connectée à une parmi les portions de puissance (1012) et la carte de signal (11), la deuxième face étant destinée à être connectée électriquement à la grille de connexion,
- Un boîtier enrobant la carte de puissance, la carte de signal et les plots de connexion,
la deuxième face des plots de connexion étant affleurante à une surface supérieure du boîtier.

## Description

La présente invention concerne le domaine de l'électronique de puissance et notamment le domaine des équipements d'alimentation de moteur électrique. La présente invention concerne plus particulièrement un module de puissance et un procédé de fabrication d'un tel module de puissance ainsi qu'un convertisseur de courant associé.

L'invention peut trouver son application, par exemple, dans les systèmes électroniques pour onduleurs de traction, pour chargeurs embarqués, pour pompes électriques de refroidissement, par exemple, de batterie, pour pompes à chaleur, pour capteurs laser, par exemple pour conduite autonome, etc...

Les modules électroniques comportent généralement des contacts permettant de connecter une carte électronique annexe comme une carte de commande d'un onduleur. Ces contacts permettent la transmission de signaux, par exemple, de commande entre le module de puissance et la carte électronique annexe.

Un module de puissance comprend typiquement une carte de puissance et des pistes électriquement conductrices, au moins une carte de signal. L'ensemble des pistes électriquement conductrices forme la grille de connexion, aussi connue sous sa dénomination anglo-saxonne « leadframe ». La grille de connexion forme les contacts vers l'extérieur du module et assure la connexion avec différents éléments du module de puissance comme expliqué ci-dessous.

La carte de puissance comprend des portions de puissance qui sont des bandes planes aménagées sur le substrat de la carte de puissance. Ces portions de puissance sont soit au potentiel B-, soit au potentiel B+, soit au potentiel Phase. La carte de puissance comprend également au moins un transistor de puissance. Les transistors de puissance permettent la conversion du courant continu et en un système de courant polyphasé et inversement. Il peut s'agir, par exemple, d'un transistor à effet de champ à grille isolée ou MOSFET pour Metal-Oxide-Semiconductor Field-Effect Transistor selon la terminologie anglo-saxonne.

Chaque portion de puissance est connectée électriquement à au moins une piste électriquement conductrice. Ainsi, chaque portion de puissance est connectée électriquement à la grille de connexion.

Enfin, un tel module de puissance de l'art antérieur comprend un boîtier enrobant la carte de puissance, la carte de signal et la grille de connexion.

Dans les modules électroniques de l'art antérieur, les transistors sont disposés sur la carte de puissance avec un espacement prédéfini pour éviter tout couplage thermique. Pour répondre à des contraintes d'encombrement, il est connu de disposer la grille de connexion au-dessus des cartes de puissance et de signal. Des piliers rigides de connexion électrique relient les transistors à la grille de connexion. On parle de module de puissance à plusieurs étages. La grille de connexion est soudée par laser aux piliers rigides.

Un tel arrangement présente certains inconvénients. D'une part, les piliers rigides soumis à des contraintes mécaniques peuvent entraîner l'endommagement des transistors. D'autre part, lors du soudage de la grille de connexion aux piliers, il y a un risque de projections métalliques sur les cartes de puissance et de signal, difficilement compatible d'une production de masse. De plus, le boîtier enrobé est obtenu par injection de résine époxy dans un moule contenant les éléments à enrober. Outre le fait que l'écoulement de la résine est complexe, il faut s'assurer au préalable de l'étanchéité de la carte de puissance et de la grille de connexion lors de l'étape d'injection. Cela conduit à avoir recours à des moules particuliers et/ou à l'ablation au laser de la résine époxy résiduelle. En outre, afin de connecter les éléments du module entre eux, les possibilités de positionnement des différents chemins de signaux sont limitées ce qui peut s'avérer problématique selon les besoins d'intégration de broches dans le module.

L'invention vise à pallier ces inconvénients en proposant un module de puissance de conception standard et ne nécessitant pas de moule particulier pour sa fabrication, ni même d'étape d'ablation au laser. L'invention propose une connexion à la grille de connexion déportée et un arrangement judicieux des portions de puissance conduisant à un module de puissance compact et directement applicable à différents systèmes électroniques, par exemple pour onduleurs de traction.

A cet effet, l'invention concerne un module de puissance destiné à être connecté à une grille de connexion, comprenant :
- Une carte de puissance comprenant un substrat du module de puissance, deux portions de puissance disposées sur le substrat,
- Une carte de signal montée sur la carte de puissance,
- Des plots de connexion électriquement conducteurs, chaque plot de connexion comprenant une première face et une deuxième face parallèle à la première face, la première face étant connectée à une parmi les portions de puissance et la carte de signal, la deuxième face étant destinée à être connectée électriquement à la grille de connexion,
- Un boîtier enrobant la carte de puissance, la carte de signal et les plots de connexion,
le module de puissance étant caractérisé en ce que la deuxième face des plots de connexion est affleurante à une surface supérieure du boîtier. Cela signifie que les plots de connexion s'étendent, préférentiellement perpendiculairement au plan du substrat, depuis une portion de puissance ou la carte de signal jusqu'à la surface supérieure du boîtier. Autrement dit, la deuxième face est apparente au niveau de la surface supérieure du boîtier. La deuxième face se situe dans un plan parallèle au plan de la zone de surface supérieure sur laquelle elle débouche, ce plan étant préférentiellement sensiblement coplanaire avec le plan de ladite zone de surface.

Grâce aux caractéristiques de l'invention, le module de puissance contient les portions de puissance et la carte de signal, chacune présentant des zones de connexion au niveau de la deuxième face des plots de connexion qui leur sont associés. Pour chaque plot de connexion, la deuxième face est située au niveau de la surface supérieure du boîtier. Ainsi, tous les éléments du module de puissance forment un premier étage et sont enrobés dans le boîtier. Les plots de connexion permettent d'assurer la connexion des portions de puissance et de la carte de signal. Ils font le lien entre le premier étage et la surface supérieure du boîtier.

Le module de puissance de l'invention n'inclut pas la grille de connexion dans son boîtier. La grille de connexion peut être connectée aux portions de puissance et à la carte de signal par le biais des plots de connexion dont la deuxième face affleure la surface supérieure du boîtier. La connexion aux portions de puissance et à la carte de signal est ainsi déportée en surface supérieure du boîtier. Le déport de la grille de connexion en dehors du module de puissance permet d'une part d'offrir une large variété de positionnements possibles des éléments dans le module puisqu'il ne faut plus tenir compte du routage des pistes électriquement conductrices au sein du boîtier, et d'autre part de faciliter la fabrication d'un tel module de puissance en rendant l'étape d'injection de résine plus simple et moins coûteuse.

Le module de l'invention présente en outre un autre avantage, celui de la standardisation du module. Les pistes électriquement conductrices ont pour rôle de former les contacts du module vers les entrées/sorties des dispositifs électroniques du client. Comme le module n'inclut pas la grille de connexion, il en ressort que le module de puissance peut être utilisé pour différents dispositifs électroniques. Seule la grille de connexion doit être adaptée aux spécificités du dispositif électronique auquel le module de puissance doit être connecté.

Selon une caractéristique optionnelle de l'invention, les deux portions de puissance sont disposées de part et d'autre de la carte de signal. Les deux portions de puissance et la carte de signal s'étendent de manière plane sur le substrat. La carte de signal est disposée entre les deux portions de puissance. Plus précisément, la carte de signal est disposée sur la carte de puissance selon une bande centrale et les deux portions de puissance sont disposées sur la carte de puissance, chacune étant adjacente à la carte de signal, d'un côté de la carte de signal et de l'autre. Les deux portions de puissance forment deux bandes parallèles entre lesquelles est montée la carte de signal.

Grâce à cette disposition des deux portions de puissance autour de la carte de signal, on évite les croisements de lignes de puissance au-dessus du substrat. Par exemple, il est possible de positionner les lignes de puissance au potentiel B+ et au potentiel B- sur une même portion de puissance, d'un même côté par rapport à la carte de signal. Ainsi la portion centrale de la carte de signal n'est pas impactée par le positionnement des lignes de puissance.

Il faut souligner que le module de puissance de l'invention est un module sans grille de connexion. Une fois connectée au module de puissance, la grille de connexion forme le deuxième étage qui se trouve donc déporté au-dessus du module de puissance. On comprend ainsi qu'étant à l'extérieur du module de puissance, la grille de connexion n'impacte pas le positionnement des plots de connexion. Le module de puissance de l'invention offre ainsi plus d'espace dans le plan du substrat pour ordonner les groupes de connexion (portions de puissance et carte de signal) selon un axe X du plan du substrat et pouvoir positionner un plus grand nombre de transistors selon un axe Y du plan du substrat, perpendiculaire à l'axe X.

Selon une caractéristique optionnelle de l'invention, la deuxième face d'au moins un plot de connexion, préférentiellement de chacun des plots de connexion connecté à la carte de signal, présente un degré de liberté en translation selon un axe perpendiculaire au plan du substrat. Autrement dit, un tel plot de connexion présente une élasticité selon une direction perpendiculaire aux faces du plot de connexion. Cela permet de maintenir les deux faces du plot de connexion parallèles entre elles lorsque le plot de connexion est comprimé selon cette direction. On parle aussi de plot déformable.

Selon une caractéristique optionnelle de l'invention, la deuxième face d'au moins un plot de connexion, préférentiellement de chacun des plots de connexion connecté aux portions de puissance, est à distance constante de la première face dudit plot de connexion. Un tel plot de connexion est aussi appelé pilier rigide. Le pilier rigide ne se déforme pas. Il est avantageusement de forme cylindrique mais peut prendre la forme de tout autre polyèdre.

Selon une caractéristique optionnelle de l'invention, la première face d'au moins un plot de connexion est connectée à la carte de signal par un moyen pris parmi le collage électriquement conducteur, le soudage ou le brasage. En ayant recours à de tels moyens électriquement conducteurs, on assure la connexion électrique des plots de connexion à la portion de puissance ou la carte de signal à laquelle il est associé.

L'invention concerne aussi un procédé de fabrication d'un module de puissance décrit précédemment. Le procédé de fabrication comprend les étapes suivantes :
- Fournir une carte de puissance comprenant un substrat du module de puissance et deux portions de puissance disposées sur le substrat, une carte de signal disposée sur le substrat, les deux portions de puissance étant préférentiellement disposées de part et d'autre de la carte de signal, des plots de connexion électriquement conducteurs, chaque plot de connexion comprenant une première face et une deuxième face parallèle à la première face, la première face étant connectée à une parmi les portions de puissance et la carte de signal,
- Disposer le substrat au fond d'un moule configuré pour délimiter au moins une surface supérieure du boîtier affleurant avec la deuxième face des plots de connexion ;
- Plaquer le substrat dans le fond du moule;
- Optionnellement, appliquer un insert sur au moins un des plots de connexion ;
- Injecter de la résine dans le moule afin d'enrober le boîtier sur la carte de puissance, la carte de signal et les plots de connexion.

Selon une caractéristique optionnelle de l'invention, le procédé de fabrication comprend, pendant l'étape d'injecter de la résine, une étape d'extraction des doigts.

Selon une caractéristique optionnelle, le substrat est plaqué au moyen de doigts et/ou au moyen des plots de connexion. Les plots ont l'avantage de plaquer la carte de puissance au fond du moule ce qui permet d'éviter la génération de flashs époxy.

A ce stade du procédé de fabrication, l'injection de la résine a débuté et permet de maintenir le substrat au fond du moule. Il n'est plus nécessaire de le plaquer contre le fond du moule par les doigts ou les plots. L'étape d'extraction des doigts libère un volume qui est alors occupé par la résine pour terminer l'enrobage du boîtier.

L'invention concerne aussi un convertisseur de courant, notamment DC/DC ou AC/DC, comprenant une carte électronique, au moins un module de puissance tel que décrit précédemment, des lignes de connexion de signal entre la carte électronique et le au moins un module de puissance, et un dissipateur thermique sur lequel le au moins un module de puissance est disposé.

Dans un mode de réalisation, le convertisseur de courant de l'invention comprend un interconnecteur, par module de puissance ou par un groupe d'au moins deux modules de puissance, comprenant au moins une piste électriquement conductrice formant les lignes de connexion de signal entre la carte électronique et le ou les modules de puissance au(x)quel(s) il est connecté. L'interconnecteur est une pièce surmoulée permettant de rassembler les pistes électriquement conductrices sur la même pièce.

Grâce au module de puissance de l'invention, la grille de connexion est séparée du module de puissance. La grille de connexion est intégrée dans l'interconnecteur qui gère les entrées et sorties client. Une telle combinaison permet à la fois de rendre plus d'espace disponible dans le plan XY du substrat pour procéder au positionnement des transistors et apporter plus de possibilités de cheminements des lignes de connexion. En outre, la séparation des lignes de puissance et de signal d'une part dans le module de puissance et des pistes électriquement conductrices d'autre part dans l'interconnecteur permet de considérer un seul type de module de puissance pour diverses applications. L'adaptation des connexions d'entrée et sortie vers l'interface client se fait au niveau de l'interconnecteur. Il en résulte que l'invention offre un module de puissance compact et standardisé quelle que soit l'application ultérieure envisagée.

L'invention porte aussi sur un véhicule automobile comprenant un tel convertisseur de courant.

D'autres caractéristiques et avantages de l'invention apparaîtront encore au travers de la description qui suit d'une part, et de plusieurs exemples de réalisation donnés à titre indicatif et non limitatif en référence aux dessins schématiques annexés d'autre part, sur lesquels :
[fig 1] représente une vue d'un module de puissance selon l'invention ;
[fig 2] représente une vue extérieure du boîtier du module de puissance selon l'invention ;
[fig 3] représente schématiquement une vue en coupe du module de puissance pendant sa fabrication ;
[fig 4] représente schématiquement une vue d'un module de puissance selon l'invention connecté à une grille de connexion.

Les caractéristiques, variantes et les différentes formes de réalisation de l'invention, telles qu'elles ont été décrites ou telles qu'elles vont être présentées dans la description détaillée qui va suivre, peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieur.

Par souci de clarté, les mêmes éléments sont désignés par les mêmes références aux différentes figures.

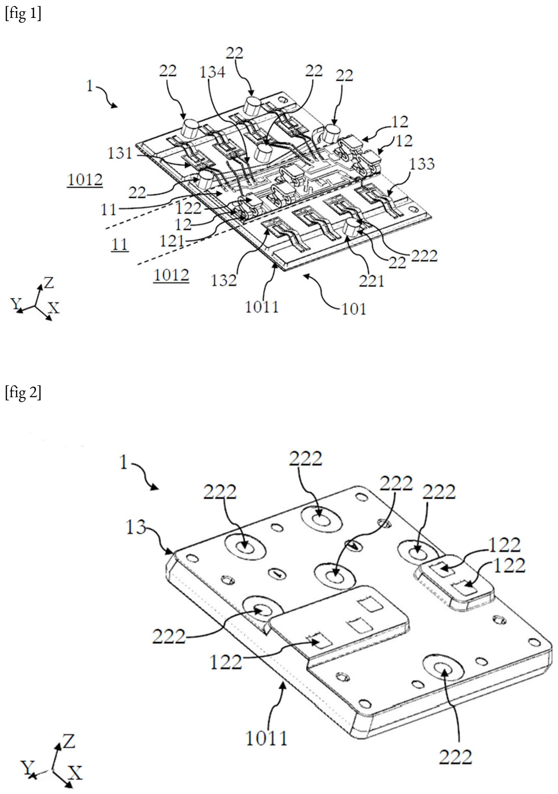

La figure 1 représente une vue d'un module de puissance 1 selon l'invention.

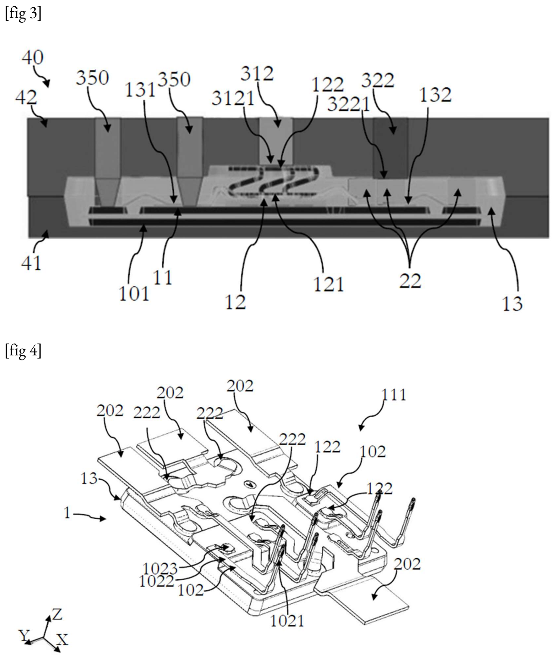

Le module de puissance 1 est destiné à être connecté à une grille de connexion 111 (visible sur la figure 4). Le module de puissance 1 comprend une carte de puissance 101 comprenant un substrat 1011 du module de puissance, deux portions de puissance 1012 disposées sur le substrat 1011. Le substrat 1011 forme le support principal du module de puissance 1. Le module de puissance 1 comprend une carte de signal 11 montée sur la carte de puissance 101. La carte de signal 11 est connectée électriquement à la carte de puissance 101.

Le module de puissance 1 comprend des plots de connexion 12, 22 électriquement conducteurs. Chaque plot de connexion 12, 22 comprend une première face 121, 221 et une deuxième face 122, 222, parallèle à la première face 121, 221. La première face 121, 221 est connectée à une parmi les portions de puissance 1012 et la carte de signal 11. La deuxième face 122, 222 est destinée à être connectée électriquement à la grille de connexion 111. Le substrat 1011 s'étendant dans un plan XY, les plots de connexion 122, 222 s'étendent selon un axe Z perpendiculaire au plan XY du substrat 1011.

Le module de puissance 1 comprend un boîtier 13 (visible sur la figure 2) enrobant la carte de puissance 101, la carte de signal 11 et les plots de connexion 12, 22. Suivant un mode de réalisation, le matériau d'enrobage du boîtier 13 est une résine époxy.

Selon l'invention, la deuxième face 122, 222 des plots de connexion 12, 22 est affleurante à une surface supérieure du boîtier 13. En d'autres termes, la deuxième face 122, 222 se situe dans le plan d'une surface supérieure du boîtier 13 du module de puissance 1. La deuxième face 122, 222 est libre de sorte à permettre une connexion électrique avec la grille de connexion.

Le module de puissance 1 de l'invention se distingue de l'art antérieur en ce qu'il n'inclut pas la grille de connexion dans le boîtier. Il offre ainsi une connexion aux portions de puissance 1012 et à la carte de signal 11 qui est déportée en surface supérieure du boîtier 13. Cet arrangement est particulièrement intéressant puisque le module de puissance n'inclut pas la grille de connexion 111 dans son boîtier 13. La connexion entre la grille de connexion 111 et la carte de puissance 101 se fait par l'intermédiaire des plots de connexion dont la deuxième face est accessible au niveau de la surface supérieure du boîtier. Il n'y a pas de parcours de pistes électriquement conductrices 102 à prévoir dans le boîtier 13. Cela évite de devoir utiliser des moules spécifiques avec un écoulement complexe pour la résine au sein du moule pendant la phase d'injection de résine pour enrober le boîtier. Comme cela apparaîtra avec la description du procédé de fabrication d'un tel module de puissance, la configuration du module de puissance 1 selon l'invention ne nécessite pas d'ablation au laser. Les avantages sont multiples comparé aux procédés de l'art antérieur : le procédé de fabrication comprend une étape en moins, et une quantité moindre de résine est requise, impliquant ainsi des coûts de production moins élevés. Un tel module de puissance 1 présente ainsi des connexions de puissance et de signal qui s'étendent selon l'axe Z perpendiculairement au plan XY du substrat.

Selon une caractéristique optionnelle de l'invention, les deux portions de puissance 1012 sont disposées de part et d'autre de la carte de signal 11. Les portions de puissance 1012 sont des bandes planes directement aménagées sur le substrat 1011, parallèles entre elles et coplanaires. Dit autrement, la carte de signal 11 est intercalée entre les deux portions de puissance 1012. La carte de signal 11 est disposée sur la carte de puissance 101 dans une position centrale et les deux portions de puissance 1012 sont disposées sur la carte de puissance 101, chacune étant adjacente à la carte de signal 11. Les deux portions de puissance 1012 et la carte de signal 11 forment ainsi trois bandes parallèles en alternance : une première portion de puissance 1012 disposée de façon contiguë à la carte de signal 11, elle-même disposée de façon contiguë à la deuxième portion de puissance 1012. Cette répartition des portions de puissance autour de la carte de signal formant des bandes parallèles entre elles est symbolisée au moyen de traits pointillés sur la figure 1.

Selon le mode de réalisation illustré sur la figure 1, la carte de puissance comprend des portions de puissance 1012 qui sont soit au potentiel B⁻, soit au potentiel B⁺ soit au potentiel Phase.

La carte de puissance 101 comprend également au moins un transistor de puissance 131, 132. Sur le module de puissance 1 de la figure 1, huit transistors sont représentés : quatre sont sur une première portion de puissance et quatre autres sont sur une deuxième portion de puissance. Bien entendu, on ne sort pas du cadre de l'invention avec un nombre différent de transistors et/ou une disposition différente. Les transistors de puissance permettent la conversion du courant continu et en un système de courant polyphasé et inversement. Il peut s'agir, par exemple, d'un transistor à effet de champ à grille isolée ou MOSFET pour Metal-Oxide-Semiconductor Field-Effect Transistor selon la terminologie anglo-saxonne.

De manière connue, chaque transistor 131, 132 est connecté par des moyens de connexion électrique 133, 134 à une portion de puissance 1012 et la carte de signal 11.

Chaque portion de puissance 1012 est destinée à être connectée électriquement à au moins une piste électriquement conductrice de la grille de connexion par l'intermédiaire d'au moins un plot de connexion 22. Les plots de connexion 22, agencés entre les portions de puissance 1012 et la grille de connexion, ont pour rôle de transmettre la puissance entre les portions de puissance 1012 et les pistes électriquement conductrices de la grille de connexion. Sur la figure 1, les plots de connexion 22 ont une forme cylindrique. Cette représentation n'est nullement limitative. Les plots de connexion peuvent être de différentes formes comme des cubes, des parallélépipèdes ou tout autre forme volumique.

La carte de signal 11 est connectée électriquement à la carte de puissance 101. La carte de signal 11 est reliée aux différents transistors de puissance de la carte de puissance 101 par les moyens de connexion 134 afin d'envoyer les signaux permettant de commander les transistors de puissance.

Sur la carte de signal 11 sont connectés électriquement des plots de connexion 12. Ces plots de connexion 12 permettent de faire transiter des signaux électriques de commande entre la carte de signal 11 et l'extérieur du module de puissance 1.

La disposition des deux portions de puissance 1012 autour de la carte de signal 11 présente l'avantage d'éviter les croisements de lignes de puissance au-dessus du substrat.

L'invention propose ainsi un module avec des connexions de puissance et de signal s'étendant vers le haut à partir du substrat de puissance, c'est-à-dire depuis le substrat et perpendiculairement au plan du substrat, assemblé en trois groupes et moulé sans grille de connexion avec la surface supérieure à l'extérieur du boîtier du module de puissance. Un premier groupe forme un contact de sortie sur un côté du module via une portion de puissance 1012 (par exemple la phase), un deuxième groupe forme un contact de signal au milieu du substrat via la carte de signal, un troisième groupe forme tous les contacts d'entrée et de sortie de puissance d'un deuxième côté (par exemple B+, B-, phase).

Cette configuration simplifie considérablement la conception d'un interconnecteur mixte destiné à coopérer avec un tel module de puissance. La conception du module de puissance est simplifiée puisqu'elle est non impactée par des interfaces spécifiques et peut être la même entre toutes les applications pour les onduleurs de traction, avec une réduction significative des coûts de développement. Considérant que l'interconnecteur mixte gère toutes les entrées et sorties client, plus d'espace est disponible dans le plan XY du substrat pour procéder au positionnement des transistors. Grâce à l'invention, seul l'interconnecteur mixte est modifié sans impact sur la conception du module de puissance. Il en résulte que l'invention offre un module de puissance compact et standardisé quelle que soit l'application ultérieure envisagée.

Selon une caractéristique optionnelle de l'invention, la deuxième face 122 d'au moins un plot de connexion 12 connecté à la carte de signal 11 présente un degré de liberté en translation selon un axe Z perpendiculaire au plan XY du substrat 1011. La première face 121 et la deuxième face 122 sont reliées par des moyens de déformation élastique. Les moyens de déformation élastique des plots de connexion 12 sont agencés de façon à assurer le parallélisme des première et deuxième faces 121, 122 lors d'une déformation de ces moyens selon une direction Z perpendiculaire aux surfaces des première et deuxième faces 121, 122.

Les plots de connexion 12 sont élastiquement déformables. Ces plots présentent donc une certaine élasticité qui leur permet de rattraper le jeu en hauteur (selon l'axe Z) dans le positionnement relatif du module de puissance et de l'interconnecteur.

La première face 121 d'au moins un plot de connexion 12 est connectée électriquement à la carte de signal 11. La connexion est réalisée par un moyen électriquement conducteur comme le soudage, par exemple laser ou ultrason, le brasage, le collage électriquement conducteur ou tout autre moyen équivalent.

Selon une caractéristique optionnelle de l'invention, la deuxième face 222 d'au moins un plot de connexion 22 connecté aux portions de puissance 1012 est à distance constante de la première face 221 dudit plot de connexion 222. Autrement dit, le plot de connexion 22 est un pilier rigide.

La figure 2 représente une vue extérieure du boîtier 13 du module de puissance 1 selon l'invention. Cette vue permet de mettre en valeur le substrat 1011 qui forme le support du module de puissance 1 et l'encapsulation par le boîtier 13 de l'ensemble des éléments constituant le module de puissance. On voit également que les deuxièmes faces 122, 222 sont affleurantes à la surface supérieure du boîtier 13. On voit ainsi qu'il suffit de disposer un interconnecteur sur la surface supérieure du boîtier 13 pour permettre la connexion des entrées/sorties du module de puissance.

La figure 3 représente schématiquement une vue en coupe du module de puissance 1 pendant sa fabrication. Le procédé de fabrication d'un tel module de puissance 1 comprend les étapes décrites ci-dessous.

La première étape est la fourniture d'une carte de puissance 101 comprenant un substrat 1011 du module de puissance et deux portions de puissance 1012 disposées sur le substrat 1011, une carte de signal 11 disposée sur le substrat, les deux portions de puissance 1012 étant préférentiellement disposées de part et d'autre de la carte de signal 11, des plots de connexion 12, 22 électriquement conducteurs, chaque plot de connexion comprenant une première face 121, 221 et une deuxième face 122, 222 parallèle à la première face, la première face 121, 221 étant connectée à une parmi les portions de puissance 1012 et la carte de signal 11. Les éléments fournis correspondent aux éléments constitutifs du module de puissance 1 qui doivent être enrobés dans de la résine, typiquement de la résine époxy, afin de les encapsuler dans un boîtier 13.

La deuxième étape est la disposition du substrat 1011 au fond d'un moule 40 configuré pour délimiter au moins une surface supérieure du boîtier 13 affleurant avec la deuxième face 122 des plots de connexion 12. Le moule est composé en une partie inférieure 41 et une partie supérieure 42. Le substrat 1011 (et les éléments montés sur le substrat fourni à la première étape) est posé au fond de la partie inférieure 41 du moule 40, la face externe du substrat étant en appui contre le fond du moule.

La troisième étape est le plaquage du substrat 1011 dans le fond du moule au moyen de doigts 350. Cette étape permet de s'assurer qu'aucun espace libre se trouve entre le substrat et le fond du moule afin d'éviter le passage de résine dans un tel espace.

La quatrième étape, optionnelle, qui peut avoir lieu avant, pendant ou après la troisième étape, est l'application d'un insert 312, 322 sur au moins un des plots de connexion 12, 22.

A un plot de connexion 12, 22 est associé un insert 312, 322 comprenant une première extrémité 3121, 3221 en contact avec la deuxième face 122, 222 dudit plot 12, 22. Un ensemble formé par un plot de connexion et son insert présente un degré de liberté en translation selon un axe perpendiculaire Z au plan du substrat XY. En d'autres termes, l'insert 312 associé au plot de connexion 12, qui présente une élasticité, est un insert fixe alors que l'insert 322 associé au plot de connexion 22, qui est un pilier rigide, est un insert mobile. Ce degré de liberté permet le rattrapage de hauteur selon l'axe Z. La partie supérieure 42 du moule étant de forme complémentaire à la forme de la surface supérieure du boîtier 13 à obtenir, la présence des inserts 312, 322 permet de rattraper localement les éventuelles différences de hauteur en Z à la fermeture du moule.

La cinquième étape est l'injection de la résine dans le moule afin d'enrober le boîtier 13 sur la carte de puissance 101, la carte de signal 11 et les plots de connexion 12, 22.

Pendant l'étape d'injecter de la résine, le procédé de fabrication comprend avantageusement une étape d'extraction des doigts 350. L'étape d'injection de la résine étant initiée, le substrat est déjà enrobé dans la résine et est ainsi maintenu plaqué contre le fond du moule. Les doigts 350 sont rétractés et de la résine vient remplir le volume laissé libre par les doigts 350.

Le procédé de fabrication qui vient d'être décrit permet l'obtention du module de puissance 1 représenté à la figure 2.

La figure 4 représente schématiquement une vue d'un module de puissance 1 selon l'invention connecté à une grille de connexion 111. La grille de connexion 111 est formée par l'ensemble des pistes électriquement conductrices 102. Comme cela est visible sur la figure 2, la surface supérieure du module de puissance 1 expose les deuxièmes faces 122, 222 des plots de connexions. Ces deuxièmes faces affleurant la surface supérieure du boîtier 13 sont le point de connexion entre la grille de connexion (comprenant les pistes électriquement conductrices 102) et les portions de puissance 1012 et la carte de signal 11.

Une extrémité d'une piste électriquement conductrice 102 peut alors être connectée à une deuxième face d'un plot de connexion par soudage au laser. Généralement, les pistes 102 sont disposées dans une pièce thermoplastique servant de support pour les pistes 102. On parle alors d'un interconnecteur.

Selon une variante possible représentée à la figure 4 à titre d'exemple, au moins une piste électriquement conductrice 102 comprend une première partie 1021 ayant une forme plane et une deuxième partie 1022 ayant une forme tridimensionnelle. La deuxième partie 1022 de la piste électriquement conductrice 102 comporte une plage de connexion 1023 formant une extrémité libre de la piste électriquement conductrice 102. La plage de connexion 1023 de la deuxième partie 1022 de la piste électriquement conductrice 102 est affleurante à une surface extérieure du boîtier 13 lorsqu'elle est disposée au-dessus du module de puissance. C'est la plage de connexion 1023 qui est soudée à la deuxième face qui lui est associée. Il s'agit ici d'un exemple de réalisation et l'invention ne se limite nullement à cette configuration de pistes 102.

De façon similaire aux pistes électriquement conductrices 102, la grille de connexion comprend aussi des conducteurs 202 associés aux portions de puissance 1012.

Il ressort de la description de l'invention que le module de puissance 1 offre une grande adaptabilité des connexions entre le module de puissance et l'interface client. Il suffit d'adapter l'interconnecteur et les cheminements de ses pistes électriquement conductrices 102.

L'invention porte aussi sur un convertisseur de courant, notamment DC/DC ou AC/DC, comprenant une carte électronique, au moins un module de puissance tel que décrit précédemment, des lignes de connexion de signal entre la carte électronique et le ou les modules de puissance, et un dissipateur thermique sur lequel le ou les modules de puissance sont disposés. Le dissipateur thermique assure l'évacuation de la chaleur produite par le ou les modules de puissance.

Dans une variante, le convertisseur de courant comprend un interconnecteur, par module de puissance ou par un groupe d'au moins deux modules de puissance, comprenant au moins une piste électriquement conductrice formant les lignes de connexion de signal entre la carte électronique et le ou les modules de puissance au(x)quel(s) il est connecté.

Bien sûr, l'invention n'est pas limitée aux exemples qui viennent d'être décrits et de nombreux aménagements peuvent être apportés à ces exemples sans sortir du cadre de l'invention. Notamment les caractéristiques de différentes variantes de réalisation de l'invention peuvent être combinées pour réaliser l'invention, dans la mesure où ces variantes ne sont pas incompatibles entre elles.

## Revendications

1. Module de puissance (1) destiné à être connecté à une grille de connexion (111), comprenant :
- Une carte de puissance (101) comprenant un substrat (1011) du module de puissance, deux portions de puissance (1012) disposées sur le substrat (1011),
- Une carte de signal (11) montée sur la carte de puissance (101),
- Des plots de connexion (12, 22) électriquement conducteurs, chaque plot de connexion (12, 22) comprenant une première face (121, 221) et une deuxième face (122, 222) parallèle à la première face (121, 221), la première face (121, 221) étant connectée à une parmi les portions de puissance (1012) et la carte de signal (11), la deuxième face (122, 222) étant destinée à être connectée électriquement à la grille de connexion (111),
- Un boîtier (13) enrobant la carte de puissance (101), la carte de signal (11) et les plots de connexion (12, 22),
le module de puissance (1) étant **caractérisé en ce que** la deuxième face (122, 222) des plots de connexion (12, 22) est affleurante à une surface supérieure du boîtier (13).

2. Module de puissance (1) selon la revendication 1, dans lequel les deux portions de puissance (1012) sont disposées de part et d'autre de la carte de signal (11).

3. Module de puissance (1) selon la revendication 1 ou 2, dans lequel la deuxième face (122) d'au moins un plot de connexion (12), préférentiellement de chacun des plots de connexion connecté à la carte de signal (11), présente un degré de liberté en translation selon un axe (Z) perpendiculaire au plan (XY) du substrat (1011).

4. Module de puissance (1) selon l'une quelconque des revendications 1 à 3, dans lequel la deuxième face (222) d'au moins un plot de connexion (22), préférentiellement de chacun des plots de connexion connecté aux portions de puissance (1012), est à distance constante de la première face (221) dudit plot de connexion (222).

5. Module de puissance (1) selon l'une quelconque des revendications 1 à 4, dans lequel la première face (121) d'au moins un plot de connexion (12) est connectée à la carte de signal (11) par un moyen pris parmi le collage électriquement conducteur, le soudage ou le brasage.

6. Procédé de fabrication d'un module de puissance (1) selon l'une quelconque des revendications 1 à 5, comprenant les étapes suivantes :
- Fournir une carte de puissance (101) comprenant un substrat (1011) du module de puissance et deux portions de puissance (1012) disposées sur le substrat (1011), une carte de signal (11) disposée sur le substrat, les deux portions de puissance (1012) étant préférentiellement disposées de part et d'autre de la carte de signal (11), des plots de connexion (12, 22) électriquement conducteurs, chaque plot de connexion comprenant une première face (121, 221) et une deuxième face (122, 222) parallèle à la première face, la première face (121, 221) étant connectée à une parmi les portions de puissance (1012) et la carte de signal (11),
- Disposer le substrat (1011) au fond d'un moule (40) configuré pour délimiter au moins une surface supérieure du boîtier (13) affleurant avec la deuxième face (122) des plots de connexion (12) ;
- Plaquer le substrat (1011) dans le fond du moule;
- Optionnellement, appliquer un insert (312, 322) sur au moins un des plots de connexion (12, 22) ;
- Injecter de la résine dans le moule afin d'enrober le boîtier (13) sur la carte de puissance (101), la carte de signal (11) et les plots de connexion (12,22).

7. Procédé de fabrication selon la revendication précédente, comprenant, pendant l'étape d'injecter de la résine, une étape d'extraction de doigts (350) par lesquels le substrat est plaqué.

8. Convertisseur de courant, notamment DC/DC ou AC/DC, comprenant une carte électronique, au moins un module de puissance selon l'une quelconque des revendications 1 à 5, des lignes de connexion de signal entre la carte électronique et le au moins un module de puissance, et un dissipateur thermique sur lequel le au moins un module de puissance est disposé.

9. Convertisseur de courant selon la revendication précédente, comprenant un interconnecteur, par module de puissance ou par un groupe d'au moins deux modules de puissance, comprenant au moins une piste électriquement conductrice formant les lignes de connexion de signal entre la carte électronique et le ou les modules de puissance au(x)quel(s) il est connecté.

10. Véhicule automobile comprenant un convertisseur de courant selon l'une quelconque des revendications 8 à 9.
